# EUROPEAN PATENT SPECIFICATION

(11) **EP 0 567 111 B1**
(45) Date of publication and mention of the grant of the patent: **17.07.1996**
(21) Application number: 93106540.3
(22) Date of filing: 22.04.1993
(51) Int. Cl.: H01L 31/0224

(54) **Electrode of a photovoltaic element and method for forming the same**
Elektrode einer photovoltaischen Vorrichtung und Verfahren zur Herstellung
Electrode d'une élément photovoltaique et sa méthode de fabrication

(30) Priority: 23.04.1992 JP 130066/92
(43) Date of publication of application: 27.10.1993
(73) Proprietor: CANON KABUSHIKI KAISHA, Tokyo (JP)
(72) Inventor: Tsuzuki, Koji, c/o Canon Kabushiki Kaisha, Tokyo 146 (JP); Takehara, Nobuyoshi, c/o Canon Kabushiki Kaisha, Tokyo 146 (JP)
(74) Representative: Tiedtke, Harro, Dipl.-Ing.

(56) References cited:
- DE-A- 3 804 831
- US-A- 4 084 985
- PATENT ABSTRACTS OF JAPAN vol. 12, no. 330 (E-655)7 September 1988 &JP-A-63 093 164
- PATENT ABSTRACTS OF JAPAN vol. 12, no. 461 (E-689)5 December 1988 &JP-A-63 185 071
- PATENT ABSTRACTS OF JAPAN vol. 14, no. 344 (E-955)25 July 1990 & JP-A-21 17 177
- PATENT ABSTRACTS OF JAPAN vol. 13, no. 264 (E-774)19 June 1989 &JP-A-10 57 762
- PATENT ABSTRACTS OF JAPAN vol. 15, no. 170 (E-1062)30 April 1991&JP-A-30 38 069

## Description

### PHOTOVOLTAIC ELEMENT AND METHOD FOR FORMING THE SAME

### BACKGROUND OF THE INVENTION

### Field of the Invention

The present invention relates to a semiconductor element having a collecting electrode superior in weathering proof, and particularly to a photovoltaic element which is easy to be fabricated and has a long-term reliability in water proof, as well as a forming method thereof.

### Related Background Art

In recent years, there are growing interests in the environment and energy problems such as warmer environments of the earth or radioactive contamination caused by several atomic power plant accidents. In these situations, solar cells using a photovoltaic semiconductor element (hereinafter also referred to as a photoelectric conversion element) have been expected worldwide as the reproducible, inexhaustible clean energy. At present, three types of solar cell have been well known: single crystal silicone type, polycrystalline silicone type, and amorphous silicon type. An amorphous silicone type solar cell is expected as one of the most promising solar cells, because it has excellent characteristics such as the easy formation of large area and the operativity with thin films due to its great light absorption coefficient, unlike the crystal type solar cell, although it is only inferior in the conversion efficiency to the crystal type solar cell. Thus, many researches for the amorphous silicone type have been made effortfully worldwide, because if the amount of power generation reaches several hundreds MW, its costs are estimated to be significantly less than the crystal type.

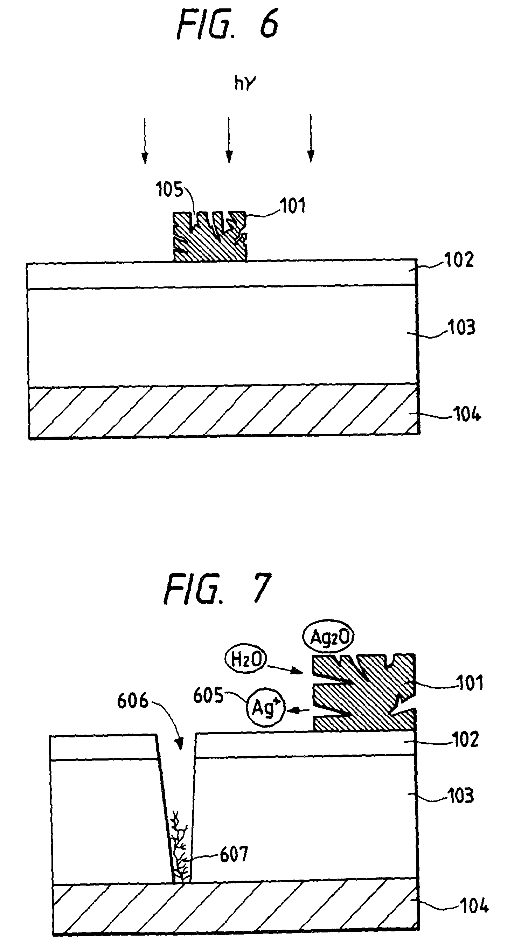

Herein, an example of a conventional solar cell is shown in Fig. 6. A photoelectric conversion layer 103 made of an amorphous silicone is formed on an electrically conductive substrate 104, and a transparent electrically conductive layer 102 also useful as an anti-reflection layer is formed thereon. Further, on the transparent electrically conductive layer is formed a collecting grid electrode 101 for collecting current more effectively. If light is incident on the photoelectric conversion layer 103 from the side of the collecting electrode 101, as shown in Fig. 6, light energy is converted into electric current within the photoelectric conversion layer, and taken out from the collecting electrode 101 and the electrically conductive substrate 104 as the outputs. The photoelectric conversion layer contains at least one or more pin junctions, with the p-side acting as an anode and the n-side as a cathode.

In general, solar cells having an output of several watts or greater are used outdoors. Therefore, these solar cells are required to have the durability against the temperature and humidity, or the environment proof. In particular, when the collecting electrode is formed on the non-single crystal photovoltaic semiconductor, it must be formed in a large area at a temperature not to damage the quality of film on the semiconductor, whereby an electroconductive paste is used.

A conventional solar cell is shown in Fig. 6. There are a number of voids or interstices 105 of various sizes in the collecting electrode 101. In the atmosphere, moisture from the outside passes through the solar cell module to permeate into such voids or interstices, and dissolve electroconductive base substance such as silver contained in the collecting electrode by photovoltaic power of the solar cell itself. Such electroconductive base substance dissolved may diffuse and grow through defective portions such as pinholes of semiconductor, causing a short-circuit between the positive and negative electrodes of the solar cell, resulting in a problem of greatly decreasing the conversion efficiency. For example, when the electroconductive base substance is silver, the reaction occurs between the anode and the cathode, according to the following formula, thereby giving rise to a short-circuit. ${\text{Anode Ag}}_{\text{2}} {\text{O + H}}_{\text{2}} {\text{O → 2Ag}}^{\text{+}} {\text{+ 2OH}}^{\text{-}}$${\text{Cathode Ag}}^{\text{+}} {\text{+ e}}^{\text{-}} \text{→ Ag (crystal deposition)}$

This behavior is shown in Fig. 7. A silver ion 605 produced by the reaction between Ag₂O and water within the collecting electrode 101 of the anode side enters a pinhole 606 existing in the photoelectric conversion layer 103 owing to an electromotive force produced by the photovoltaic element, sticking to the electrically conductive substrate 104 to form a crystal 607. If the crystal 607 grows, the collecting electrode 101 and the electrically conductive substrate 104 of the solar cell are short-circuited, thereby decreasing the conversion efficiency. If the reaction further progresses, the output of solar cell can not be taken out.

This electromigration phenomenon is not limited to silver, but can occur on copper, solder and gold.

In view of the above-described problem, an object of the present invention is to provide a photovoltaic element which has high environment proof, and especially is easy to fabricate with the conversion efficiency not degrading in the permeation of water contents.

### SUMMARY OF THE INVENTION

In order to accomplish the above-mentioned object, the present invention provides a photovoltaic element having a photoelectric conversion layer and a collecting electrode formed by curing a paste having at least a conductive base substance and a curable resin on said photoelectric conversion layer, wherein the average molecular weight of said curable resin is 3000 or less, and wherein the weight ratio of said electroconductive base substance to said collecting electrode is 70% or more, and wherein said curable resin contains at least one kind of urethan type, epoxy type, polyimide type, polyester type, phenol type, vinyl type, and acrylic type.

Also, the present invention provides a method for forming a photovoltaic element, wherein said curing is performed in a range from 120°C to 250°C, and wherein said electroconductive base substance is any one of silver, silver palladium alloy, a mixture of silver and carbon, copper, nickel, aluminum, and gold, and wherein said photovoltaic element is non-single crystal semiconductor, further including the steps of forming a paste having an electroconductive base substance and a curable resin having an average molecular weight of 3000 or less on said photoelectric conversion layer, and forming a collecting electrode by curing said paste.

### BRIEF DESCRIPTION OF THE DRAWINGS

Fig. 1 is a typical cross-sectional view of a photovoltaic element having a collecting electrode according to the present invention.

Fig. 2 is a graphical representation of the temporal change of leak current flowing through photovoltaic elements using collecting electrodes in example 1 and comparative example.

Fig. 3 is a graphical representation of the temporal change of leak current flowing through photovoltaic elements using collecting electrodes in example 2 and comparative example.

Fig. 4 is a graphical representation of the temporal change of leak current flowing through photovoltaic elements using collecting electrodes in example 3.

Fig. 5 is a graphical representation of the relation of a photovoltaic element using a collecting electrode between the number average molecular weight and the leak current.

Fig. 6 is a typical cross-sectional view of a conventional photovoltaic element using a collecting electrode.

Fig. 7 is an explanation view of the principle for degradation in the conventional photovoltaic element using the collecting electrode.

### DETAIL DESCRIPTION OF THE PREFERRED EMBODIMENTS

As previously described, if some voids or interstices exist in a collecting electrode, moisture entering from the outside may react with electroconductive base substance such as silver, producing silver ions to give rise to a short-circuit between electrodes.

In the present invention, the curable resin as the electroconductive paste has an average molecular weight of 3000 or less, with a greater mobility of resin, the resin extending across the collecting electrode, which makes it difficult to produce voids or interstices. Accordingly, water contents become less liable to reach the electroconductive base substance, so that it is possible to suppress the reaction of the chemical formula (A) as previously noted, and thus the creation of silver ions. As a result, it is possible to prevent the short-circuit between electrodes.

Even if silver ions are produced, the curable resin having a number average molecular weight of 3000 or less has a greater mobility of resin, which causes the resin to sink more or less, whereby silver ions become difficult to reach the transparent conductive layer, thereby making it possible to prevent the short-circuit.

Moreover, because of the great mobility of resin, it is easy to form the paste on the photoelectric conversion layer by screen printing.

As above described, according to the present invention, it is possible to provide a photovoltaic element which is unlikely to cause electromigration and has excellent environment proof. Also, since the conversion efficiency is not degraded, the total costs for the photovoltaic element can be reduced.

A solar cell according to the present invention is made up in the following way, when amorphous silicon deposited on a conductive substrate is used as a photoelectric conversion semiconductor layer.

On the conductive substrate, an amorphous silicon layer having at least one or more pin junctions is formed by plasma CVD using silane gas, for example. Preferable examples of the conductive substrate include stainless, aluminum, copper, titanium, carbon sheet and so on. Also, the substrate may be a resin substrate having a metal deposited thereon. Subsequently, on the silicon layer is formed a transparent conductive layer made of indium oxide or tin oxide by vapor deposition or spraying.

And an electroconductive paste composed of an electroconductive base substance and a curable resin is applied on the transparent conductive layer by screen printing, and cured at a temperature ranging from 100 to 200°C to form a collecting electrode.

Examples of the electroconductive base substance in the electroconductive paste include silver, silver-palladium alloy, a mixture of silver and carbon, copper, nickel, aluminum, gold and so on. A grid electrode preferably contains an electroconductive base substance of at least 70 wt%, and more preferably at 75 wt% or greater, in order to obtain an electric conductivity necessary for passing the electric current. Preferable examples of the curable resin include urethan type, epoxy type, polyimide type, polyester type, phenol type, vinyl type, and acrylic type, whose average molecular weight is 3000 or less. Particularly, the epoxy type is most preferable from the viewpoint of the waterproof and the economy. Since impurities such as chlorine or sodium contained in the electroconductive paste will act as the catalyst in the above-mentioned electromigration reaction and promote the creation of metallic ions, it is preferable to contain as least amount of impurities as possible.

Also, the extent of voids or interstices in the collecting electrode generally depends on the kind of resin for forming the collecting electrode, as well as the temperature and time in forming, but if a sufficient curable time is given at a temperature of 120°C or greater, the crosslinking degree of resin is not substantially changed, resulting in little change in the extent of voids or interstices. Further, when the paste is used as the collecting electrode for the photovoltaic electrode which is an amorphous semiconductor, the forming temperature is substantially in a range from 120°C to 250°C, depending on the kind of resin. At temperature of 120°C or below, the crosslinking of the resin in the paste is insufficient so that the electrical conductivity or adhering force may be reduced, while at temperatures of 250°C or above, the film quality of amorphous semiconductor is degraded.

The present invention will be now described in detail by way of examples. Note that the number average molecular weight of the curable resin in the present invention was measured by a gel permeation chromatography (GPC). The gel permeation chromatography used herein is that using a property that the adsorbent can adsorb more sample having smaller molecular weight, a sample for measurement is passed through a column (like a pipe of adsorbent) which is held thermostatic, whereby the average molecular weight is determined by the adsorbed amount and the time.

### Example 1

Two pin-type photoelectric conversion layers composed of amorphous silicon were deposited on a stainless substrate having a thickness of 203 µm (8 mils) and an area of 16 cm² by plasma CVD, and a transparent conductive layer composed of indium oxide was adhered thereto by sputtering.

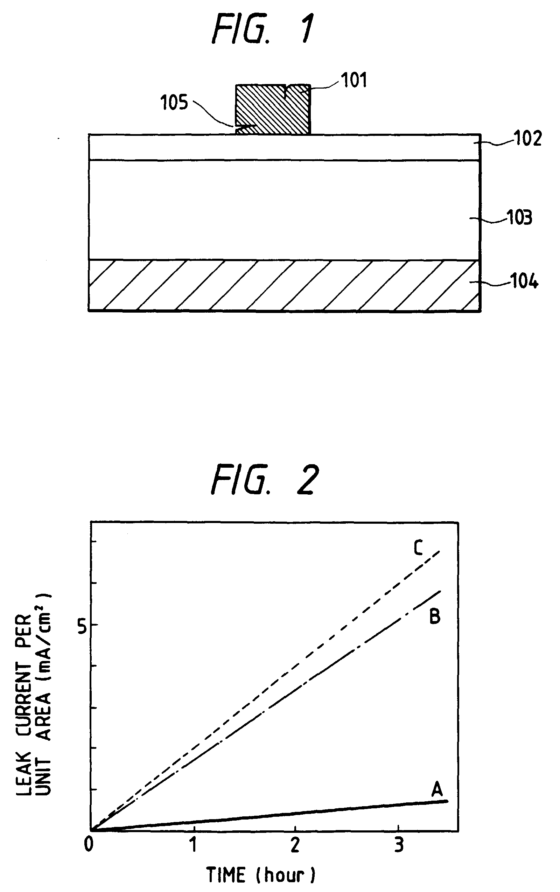

Then, an electroconductive paste composed of a urethan type resin and silver particulates (70 wt% electroconductive base substance, 20 wt% urethan type resin with an average molecular weight of 2010, 10 wt% solvent (methyl ethyl ketone)) was screen printed into a desired shape, and cured at a temperature of 130°C for one hour to make up a solar cell of this example. This solar cell is referred to as a tandem type, its optimal operation voltage being 1.2 V. A forward bias of 1.2 V was applied to this solar cell under the conditions of a high temperature of 85°C and a high humidity of 85%RH to appropriately measure the temporal change of leak current flowing within the solar cell. The forward bias was applied to simulate the operation state. The measurement result is indicated by the solid line A in Fig. 2. The axis of ordinates of Fig. 2 indicates the leak current per unit area, and the axis of abscissas indicates the time.

### Comparative example

As a comparative example, using an electroconductive paste composed of a polyimide type resin (with an average molecular weight of 14400) and silver particulates and an electroconductive paste composed of a polyester type resin (with an average molecular weight of 31000) and silver particulates, a solar cell was fabricated under the same conditions as in the example 1, and the same test as above was performed. This result is shown in Fig. 2. In Fig. 2, the polyimide type resin (with an average molecular weight of 14400) is indicated by the dot-and-dash line B, while the polyester type resin (with a number average molecular weight of 31000) is indicated by the broken line C.

As can be seen from Fig. 2, the leak current of the solar cell in the comparative example has greatly increased such as 1.7 mA/cm² for the polyimide type per hour, and 2 mA/cm² per hour for the polyester type, while the solar cell in the example 1 is 0.2 mA/cm² per hour, which is about one-tenth that of the comparative example, indicating that the elution of silver has greatly reduced.

### Example 2

In the same way as in the example 1, a tandem-type solar cell was fabricated using a paste composed of an epoxy type resin and silver particulates (80 wt% electroconductive base substance, 20 wt% epoxy resin with an average molecular weight of 540, solventless). The curing conditions were 150°C and three hours.

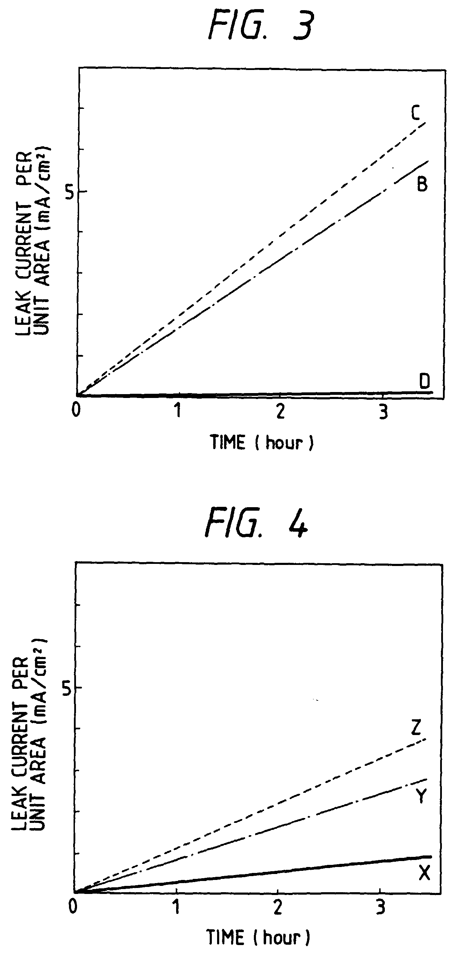

In the same way as in example 1, a forward bias was applied to this solar cell under the conditions of a high temperature of 85°C and a high humidity of 85%RH to measure the increase amount of leak current. This result is shown in Fig. 3 together with that of the comparative example. In Fig. 3, the solid line D indicates the leak current in this example, while the dot-and-dash line B and the dotted line C indicate the temporal change of leak current for the polyimide type resin (with an average molecular weight of 14400) and the polyester type resin (with an average molecular weight of 31000) of the comparative example, respectively, as shown in Fig. 2.

In this example, the increase amount of leak current was 0.03 mA/cm² per hour, which was about 1/100 that of the comparative example. This is substantially 1/10 that of the example 1, which indicates that further great effects can be expected by using an electroconductive paste composing of a resin having a smaller number average molecular weight.

### Example 3

Using a paste composed of an unsaturated polyester type resin and silver particulates, tandem-type amorphous solar cells X, Y and Z of the polyester type resin were fabricated in the same way as in the example 1, except that the average molecular weight of unsaturated polyester type resin was 2900 for X, 3350 for Y and 5000 for Z. In the same way as in example 1, a forward bias was applied to this solar cell under the conditions of a high temperature of 85°C and a high humidity of 85%RH to measure the temporal change of leak current. This result is shown in Fig. 4. In Fig. 4, the solid line X indicates the temporal change of leak current when using a paste wherein the average molecular weight of unsaturated polyester type resin is 2900, the dotted line Y indicates the temporal change of leak current when using a paste wherein the average molecular weight of unsaturated polyester type resin is 3350, and the dot-and-dash line Z indicates the temporal change of leak current when using a paste wherein the average molecular weight of unsaturated polyester type resin is 5000.

The increase rate of leak current is a very small value such as 0.25 mA/cm² when using a paste as indicated the solid line X, with a very small migration of silver, while the amount of leak current increases when using pastes of the dotted line Y and the dot-and-dash line Z which have greater molecular weights, and in particular, when using a paste of the dot-and-dash line Z, it can be found that the leak current is 1.1 mA/cm², which is roughly four to five times that of a paste as indicated by the solid line X. This suggests that even though the same unsaturated polyester type resin is used, the amount of elution for silver will vary depending on the molecular weight, providing different characteristics as to migration resistance.

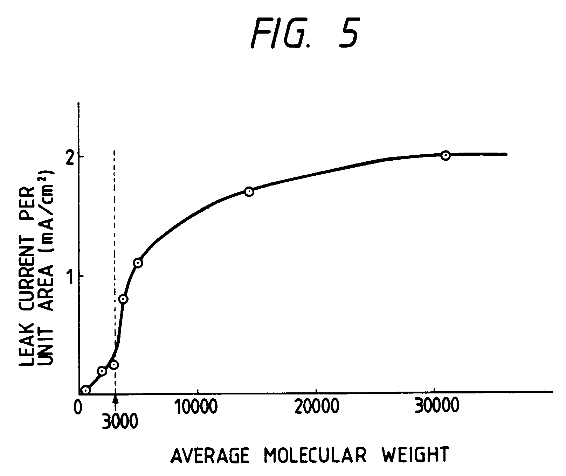

The results of the examples 1 to 3 and the comparative example as above described are listed in Table 1 and Fig. 5.

**Table 1**

| Resin | Average molecular weight | Increase of leak current (mA/cm²) | Evaluation |
|---|---|---|---|
| Epoxy | 540 | 0.03 | ○ |
| Urethan | 2010 | 0.2 | ○ |
| Unsaturated polyester | 2900 | 0.25 | ○ |
| Unsaturated polyester | 3350 | 0.8 | △ |
| Unsaturated polyester | 5000 | 1.1 | x |
| Polyimide | 14400 | 1.7 | x |
| Polyester | 31000 | 2.0 | x |

As can be seen from Fig. 5, there is a marked difference in the increase rate of leak current between a paste using a resin having an average molecular weight of 3000 or less and a paste using a resin having an average molecular weight of 3000 or greater, and the paste having an average molecular weight of 3000 or less has an excellent characteristic in the migration resistance. Also, it can be seen that greater effects can be obtained with smaller number average molecular weight.

According to the present invention, the use of a collecting electrode composed of a resin having an average molecular weight of 3000 or less makes it possible to prevent the short-circuit between electrodes of a photovoltaic element from occurring due to permeation of water contents, and to provide a solar cell which is easy to fabricate and excellent in the environment proof.

Also, because the collecting electrode is composed of a mixture of a resin and an electroconductive base substance, the grid can be formed at low temperatures, whereby it is possible to fabricate a solar cell inexpensively.

Further, since the grid containing a resin according to the present invention is bendable and strong against mechanical impacts, it is possible to provide a photovoltaic element which is flexible and rugged.

As above described, according to the present invention, it is possible to supply a solar cell excellent in the environment proof at lower costs, and its industrial values are quite remarkable.

## Claims

1. A photovoltaic element having a photoelectric conversion layer and a collecting electrode formed by curing a paste having at least an electroconductive base substance and a curable resin on said photoelectric conversion layer, characterized in that the average molecular weight of said curable resin is 3000 or less.

2. The photovoltaic element according to claim 1, characterized in that the weight ratio of said electroconductive base substance to that of said collecting electrode is 70% or more.

3. The photovoltaic element according to claim 1, characterized in that said curable resin contains at least one kind of urethan type, epoxy type, polyimide type, polyester type, phenol type, vinyl type, and acrylic type.

4. The photovoltaic element according to claim 1, characterized in that said electroconductive base substance is any one of silver, silver palladium alloy, a mixture of silver and carbon, copper, nickel, aluminum, and gold.

5. The photovoltaic element according to claim 1, characterized in that said photovoltaic element is non-single crystal semiconductor.

6. A method for forming a photovoltaic element according to claim 1, including the steps of:
forming a paste having an electroconductive base substance and a curable resin having an average molecular weight of 3000 or less on said photoelectric conversion layer; and
forming a collecting electrode by curing said paste.

7. The method according to claim 6 , characterized in that said curing is performed in a range from 120°C to 250°C.

## Patentansprüche

1. Photoelement mit einer photoelektrischen Umwandlungsschicht und einer durch das Aushärten einer Paste mit zumindest einer elektrisch leitenden Grundsubstanz und einem aushärtenden Harz auf der photoelektrischen Umwandlungsschicht ausgebildeten Sammelelektrode, **dadurch gekennzeichnet, daß** das durchschnittliche Molekulargewicht des aushärtenden Harzes 3000 oder weniger beträgt.

2. Photoelement nach Anspruch 1, **dadurch gekennzeichnet, daß** das Gewichtsverhältnis der elektrisch leitenden Grundsubstanz zu dem der Sammelelektrode 70% oder mehr beträgt.

3. Photoelement nach Anspruch 1, **dadurch gekennzeichnet, daß** das aushärtende Harz zumindest eine Sorte von Urethan, Epoxid, Polyamid, Polyester, Phenol, Vinyl und Akryl enthält.

4. Photoelement nach Anspruch 1, **dadurch gekennzeichnet, daß** die elektrisch leitende Grundsubstanz eine von Silber, einer Silber-Palladium-Legierung, einem Gemisch von Silber und Kohlenstoff, Kupfer, Nickel, Aluminium und Gold ist.

5. Photoelement nach Anspruch 1, **dadurch gekennzeichnet, daß** das Photoelement ein Nicht-Einkristall-Halbleiter ist.

6. Verfahren zum Ausbilden eines Photoelements nach Anspruch 1 mit den Schritten
eines Ausbildens einer Paste mit einer elektrisch leitenden Grundsubstanz und einem aushärtenden Harz mit einem durchschnittlichen Molekulargewicht von 3000 oder weniger auf der photoelektrischen Umwandlungsschicht und
eines Ausbildens einer Sammelelektrode durch Aushärten der Paste.

7. Verfahren nach Anspruch 6, **dadurch gekennzeichnet, daß** das Aushärten in einem Bereich von 120°C bis 250°C durchgeführt wird.

## Revendications

1. Elément photovoltaïque ayant une couche de conversion photoélectrique et une électrode collectrice formées par mûrissement d'une pâte ayant au moins une substance de base électroconductrice et une résine durcissable sur ladite couche de conversion photoélectrique, caractérisé en ce que le poids moléculaire moyen de ladite résine durcissable est de 3000 ou moins.

2. Elément photovoltaïque selon la revendication 1, caractérisé en ce que le rapport en poids de ladite substance de base électroconductrice à ladite électrode collectrice est de 70 % ou plus.

3. Elément photovoltaïque selon la revendication 1, caractérisé en ce que ladite résine durcissable contient au moins l'un du type uréthanne, du type époxy, du type polyimide, du type polyester, du type phénol, du type vinyle et du type acrylique.

4. Elément photovoltaïque selon la revendication 1, caractérisé en ce que ladite substance de base électroconductrice est l'un quelconque de l'argent, d'un alliage d'argent et de palladium, d'un mélange d'argent et de carbone, du cuivre, du nickel, de l'aluminium et de l'or.

5. Elément photovoltaïque selon la revendication 1, caractérisé en ce que ledit élément photovoltaïque est un semiconducteur non monocristallin.

6. Procédé de formation d'un élément photovoltaïque selon la revendication 1, comprenant les étapes dans lesquelles :
on forme une pâte ayant une substance de base électroconductrice et une résine durcissable ayant un poids moléculaire moyen de 3000 ou moins sur ladite couche de conversion photoélectrique ; et
on forme une électrode de cathode en faisant mûrir ladite pâte.

7. Procédé selon la revendication 6, caractérisé en ce que ledit mûrissement est effectué dans une plage de 120°C à 250°C.
